# EUROPEAN PATENT APPLICATION

(11) **EP 2 891 597 A1**
(43) Date of publication of application: **08.07.2015**
(21) Application number: 12883797.8
(22) Date of filing: 30.08.2012
(51) Int. Cl.: B62K 17/00, B62K 3/00

(54) **SELF-BALANCING MOBILE BODY AND LOAD DETECTION DEVICE**

(71) Applicant: Toyota Jidosha Kabushiki Kaisha, Toyota-shi, Aichi 471-8571 (JP)
(72) Inventor: TAIRA, Tetsuya, Toyota-shi Aichi 471-8571 (JP); BITOH, Hiroshi, Toyota-shi Aichi 471-8571 (JP)
(74) Representative: Albutt, Anthony John
(86) International application number: PCT/JP2012/005503
(87) International publication number: WO 2014/033788

(57) **Abstract**

An inverted vehicle according to the present invention includes: a riding portion on which the rider rides; an output portion that outputs a signal; an input portion that receives an input of the signal output from the output portion; a passing/blocking portion which is connected so as to be located between the output portion and the input portion in the riding portion and includes a passing portion that allows the signal to pass therethrough and a blocking portion that blocks passage of the signal; a main support portion that elastically supports the riding portion so that the blocking portion is located between the output portion and the input portion to block passage of the signal when no load is applied to the riding portion, and is compressed and deformed so that the passing portion is located between the output portion and the input portion to allow passage of the signal when a load is applied to the riding portion; and a control portion that performs an inverted traveling control of the inverted vehicle when the signal is passing through a path between the output portion and the input portion.

## Description

### Technical Field

The present invention relates to an inverted vehicle and a load detection device, and more particularly, to a technique that enables detection of a load when a control is performed based on whether a load is applied or not.

### Background Art

It is required that an inverted two-wheel vehicle ensure the stability of control thereof. From the viewpoint of functional safety, there is a demand for detecting whether or not a rider is riding on the inverted two-wheel vehicle. This is because if it is not possible to detect whether or not the rider is riding on the inverted two-wheel vehicle, an appropriate control cannot be performed according to the riding state of the rider.

In this regard, Patent Literature 1 discloses a rider detector in a transporter. When a rider steps on the transporter, the rider detector is displaced until a stem disposed below a plate interrupts a light beam. Then, when the rider steps off of the transporter, the plate returns to a raised configuration, thereby re-establishing the state in which the light beam is not interrupted. However, this rider detector adopts a structure to detect whether or not a rider is riding on the transporter which is different from the present invention to be described below.

### Citation List

### Patent Literature

Patent Literature 1: Japanese Patent No. 4162995

### Summary of Invention

### Technical Problem

The present invention has been made based on the above-mentioned findings, and an object of the present invention is to provide an inverted vehicle and a load detection device which are capable of detecting a load when a control is performed based on whether the load is applied or not.

### Solution to Problem

An inverted vehicle according to a first aspect of the present invention is an inverted vehicle that travels with a rider riding thereon, the inverted vehicle including: a riding portion on which the rider rides; an output portion that outputs a signal in a lower portion of the riding portion; an input portion that receives, in the lower portion of the riding portion, an input of the signal output from the output portion; a passing/blocking portion connected so as to be located between the output portion and the input portion in the lower portion of the riding portion, the passing/blocking portion including: a passing portion that allows the signal to pass therethrough; and a blocking portion that blocks passage of the signal; a main support portion that elastically supports the riding portion so that the blocking portion is located between the output portion and the input portion to block passage of the signal when no load is applied to the riding portion, and is compressed and deformed so that the passing portion is located between the output portion and the input portion to allow passage of the signal when a load is applied to the riding portion; and a control portion that performs an inverted traveling control of the inverted vehicle when the signal is passing through a path between the output portion and the input portion.

A load detection device according to a second aspect of the present invention includes: a load receiving portion that receives an externally-applied load; an output portion that outputs a signal in a lower portion of the load receiving portion; an input portion that receives, in the lower portion of the load receiving portion, an input of the signal output from the output portion; a passing/blocking portion connected so as to be located between the output portion and the input portion in the lower portion of the load receiving portion, the passing/blocking portion including: a passing portion that allows the signal to pass therethrough; and a blocking portion that blocks passage of the signal; and a main support portion that elastically supports the load receiving portion so that the blocking portion is located between the output portion and the input portion to block passage of the signal when no load is applied to the load receiving portion, and is compressed and deformed so that the passing portion is located between the output portion and the input portion to allow passage of the signal when a load is applied to the load receiving portion. Upon receiving an input of the signal, the input portion outputs a notification signal to notify that the signal is passing through a path between the output portion and the input portion.

### Advantageous Effects of Invention

According to the above-mentioned aspects of the present invention, it is possible to provide an inverted vehicle and a load detection device which are capable of detecting a load when a control is performed based on whether or not the load is applied.

### Brief Description of Drawings

Fig. 1 is a view showing a schematic structure of an inverted two-wheel vehicle according to a first embodiment;
Fig. 2 is a diagram showing an internal structure of a step portion according to the first embodiment;
Fig. 3 is a diagram showing the state of the step portion when no rider is on the vehicle;
Fig. 4 is a diagram showing the state of the step portion when a rider is on the vehicle;
Fig. 5A is a conceptual diagram showing the relationship between a laser beam and a slit plunger when no rider is on the vehicle;
Fig. 5B is a conceptual diagram showing the relationship between the laser beam and the slit plunger when no rider is on the vehicle;
Fig. 6 is an appearance diagram of the step portion according to the first embodiment;
Fig. 7 is a diagram showing a first example of a transmission path of a laser beam within the step portion;
Fig. 8 is a diagram showing a second example of the transmission path of the laser beam within the step portion;
Fig. 9 is a block diagram showing a structure of a control device according to the first embodiment;
Fig. 10 is a flowchart showing processing of the inverted two-wheel vehicle according to the first embodiment;
Fig. 11 is a diagram showing an internal structure of a step portion according to a second embodiment;
Fig. 12 is a diagram showing the state of the step portion when no rider is on the vehicle;
Fig. 13 is a diagram showing the state of the step portion when the rider whose weight is less than or equal to an allowable weight is on the vehicle;
Fig. 14 is a diagram showing the state of the step portion when the rider whose weight is more than the allowable weight is on the vehicle; and
Fig. 15 is a flowchart showing processing of an inverted two-wheel vehicle according to the second embodiment.

### Description of Embodiments

### <First Embodiment of the Invention>

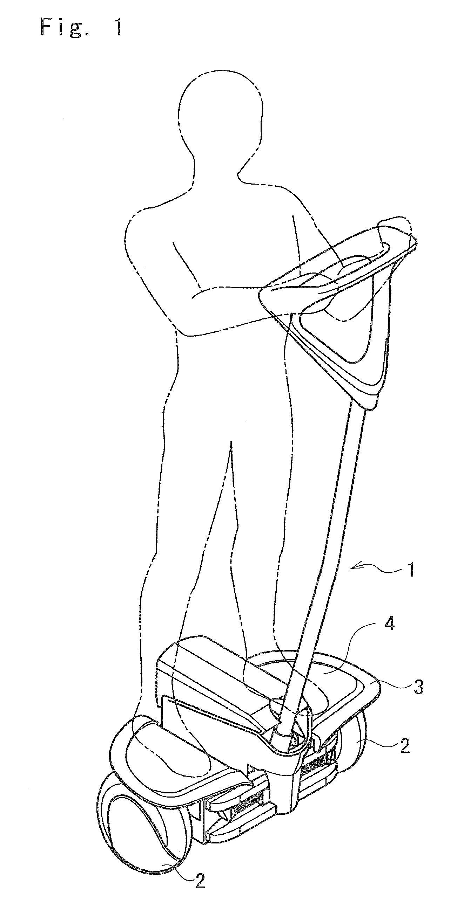

An inverted two-wheel vehicle 1 according to a first embodiment of the present invention will be described with reference to Fig. 1. Fig. 1 is a view showing the schematic structure of the inverted two-wheel vehicle 1 according to the first embodiment of the present invention.

The inverted two-wheel vehicle 1 includes a pair of wheels 2 and a step portion 3. The step portion 3 is provided with a cover 4 having a plate-like body on which the feet of a rider are placed when the rider rides on the inverted two-wheel vehicle 1.

The inverted two-wheel vehicle 1 uses a sensor to detect a posture angle of the inverted two-wheel vehicle 1 in the front-back direction when the rider riding on the cover 4 of the step portion 3 applies a load in the front-back direction of the inverted two-wheel vehicle 1. Based on the detection result, the inverted two-wheel vehicle 1 controls motors, which drive the right and left wheels 2, so as to maintain the inverted state of the inverted two-wheel vehicle 1. Specifically, the inverted two-wheel vehicle 1 controls the motors, which drive the right and left wheels 2, in the following manner. That is, when the rider riding on the step portion 3 applies a load forward to thereby incline the inverted two-wheel vehicle 1 forward, the inverted two-wheel vehicle 1 is accelerated forward so as to maintain the inverted state of the inverted two-wheel vehicle 1. When the rider applies a load backward to thereby incline the inverted two-wheel vehicle 1 backward, the inverted two-wheel vehicle 1 is accelerated backward so as to maintain the inverted state of the inverted two-wheel vehicle 1.

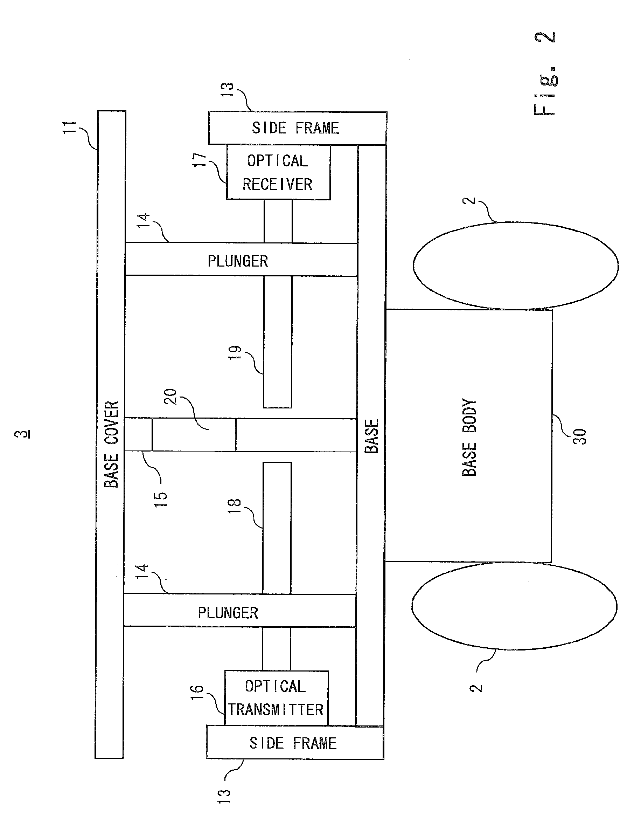

Referring next to Fig. 2, the internal structure of the step portion 3 according to the first embodiment of the present invention will be described. Fig. 2 is a diagram showing the internal structure of the step portion 3 according to the first embodiment of the present invention.

The step portion 3 includes a base cover 11, a base 12, side frames 13, plungers 14, a slit plunger 15, an optical transmitter 16, an optical receiver 17, a transmitting-side optical transmission path 18, and a receiving-side optical transmission path 19.

The base cover 11 corresponds to the cover 4 of the step portion 3 and is formed above the step portion 3. When the rider gets on the inverted two-wheel vehicle 1, the rider steps on the base cover 11. The plungers 14 and the slit plunger 15 are each connected to a lower portion of the base cover 11.

The base 12 is provided in a lower portion of the step portion 3. The plungers 14 and the split plunger 15 are each connected to an upper portion of the base 12. That is, the base cover 11 and the base 12 are connected to each other with the pair of plungers 14 and the split plunger 15 interposed therebetween. Lower portions of the pair of side frames 13 are respectively connected to both ends of the base 12. An upper portion of a base body 30 is attached to a lower portion of the base 12. The wheels 2 are respectively mounted at both ends of the base body 30.

The side frames 13 are respectively provided on both sides of the step portion 3. The inner surface of one side frame 13 is opposed to the inner surface of the other side frame 13. One of the opposed inner surfaces is mounted with the optical transmitter 16 and the other of the opposed inner surfaces is mounted with the optical receiver 17.

The plungers 14 elastically support the base cover 11. At least a part of each plunger 14 includes an elastic body. The base cover 11 is elastically supported by the elastic force of the elastic body. In this case, the elastic body is, for example, rubber or a spring. The plungers 14 each have a modulus of elasticity that allows the plungers 14 to be compressed and deformed by a load applied from the base cover 11 when the rider steps on the base cover 11 and a load of a predetermined value or more is applied to the base cover 11. Any load that is assumed to be applied when the rider is on the vehicle can be determined to be the predetermined value.

The step portion 3 may be provided with at least one plunger 14, but it is preferable that the step portion 3 be provided with a plurality of plungers 14 as shown in Fig. 2 so as to stably support the base cover 11. In this case, the plungers 14 may be arranged symmetrically about the center of gravity of the base cover 11, or about the central axis of the base cover 11 with respect to the front-back direction or the right-left direction, to thereby support the base cover 11 in a balanced manner.

At least a part of the slit plunger 15 includes an elastic body. The base cover 11 is elastically supported by the elastic force of the elastic body. The slit plunger 15 has a modulus of elasticity that allows the slit plunger 15 to be compressed and deformed together with the plungers 14 by a load applied from the base cover 11 when the rider steps on the base cover 11 and the load of the predetermined value or more is applied to the base cover 11.

The slit plunger 15 is connected to both the base cover 11 and the base 12 so as to be located on a transmission path of a laser beam to be transmitted between the optical transmitter 16 and the optical receiver 17. The slit plunger 15 is formed of a light-blocking material that blocks passage of a laser beam and blocks transmission of a laser beam. A part of the slit plunger 15 includes a slit 20 through which a laser beam passes. In the case where the slit plunger 15 is compressed and deformed when the rider steps on the base cover 11, the slit plunger 15 is deformed in such a manner that the slit 20 is located on the transmission path between the optical transmitter 16 and the optical receiver 17 (between the transmitting-side optical transmission path 18 and the receiving-side optical transmission path 19).

As a result, the laser beam transmitted from the optical transmitter 16 through the transmitting-side optical transmission path 18 passes through the slit 20, is transmitted through the receiving-side optical transmission path 19, and reaches the optical receiver 17. That is, when the laser beam transmitted from the optical transmitter 16 is received by the optical receiver 17, it can be determined that the rider is riding on the inverted two-wheel vehicle 1.

In this case, the slit 20 is a hole through which a laser beam passes. However, the slit 20 may have any shape such as a circle or a rectangle. Further, the slit 20 is not limited to being a hole, as long as the slit allows at least a laser beam to pass therethrough. For example, the slit 20 may be filled with a light transmissive material.

The optical transmitter 16 generates a laser beam and transmits the laser beam to the optical receiver 17. The optical transmitter 16 is mounted on the inner surface of the side frame 13 so as to be opposed to the optical receiver 17.

The optical receiver 17 receives the laser beam transmitted from the optical transmitter 16. The optical receiver 17 is mounted on the inner surface of the side frame 13 so as to be opposed to the optical transmitter 16.

The transmitting-side optical transmission path 18 and the receiving-side optical transmission path 19 transmit the laser beam transmitted from the optical transmitter 16 to the optical receiver 17. The transmitting-side optical transmission path 18 and the receiving-side optical transmission path 19 are, for example, optical fibers or free space (air). As described above, when no rider steps on the base cover 11 and the slit 20 of the slit plunger 15 is not located between the transmitting-side optical transmission path 18 and the receiving-side optical transmission path 19, the laser beam transmitted through the transmitting-side optical transmission path 18 is blocked by the slit plunger 15.

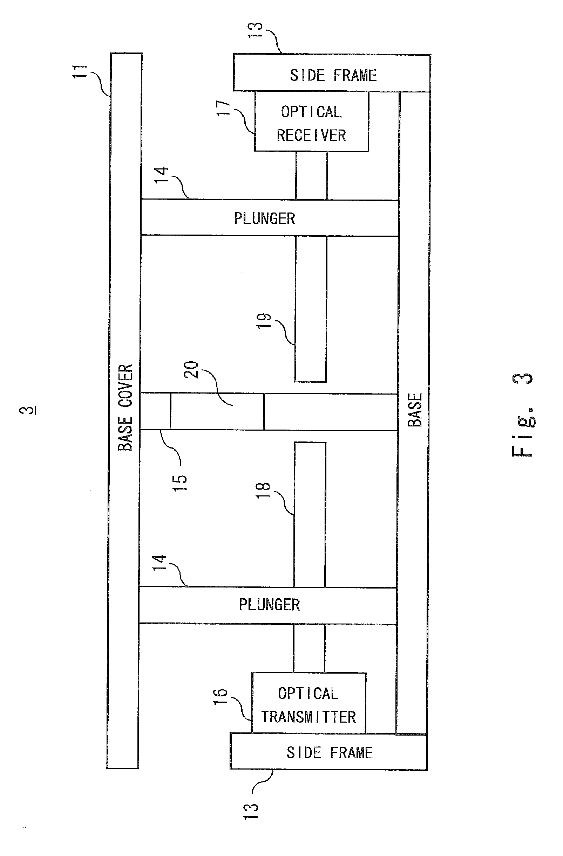

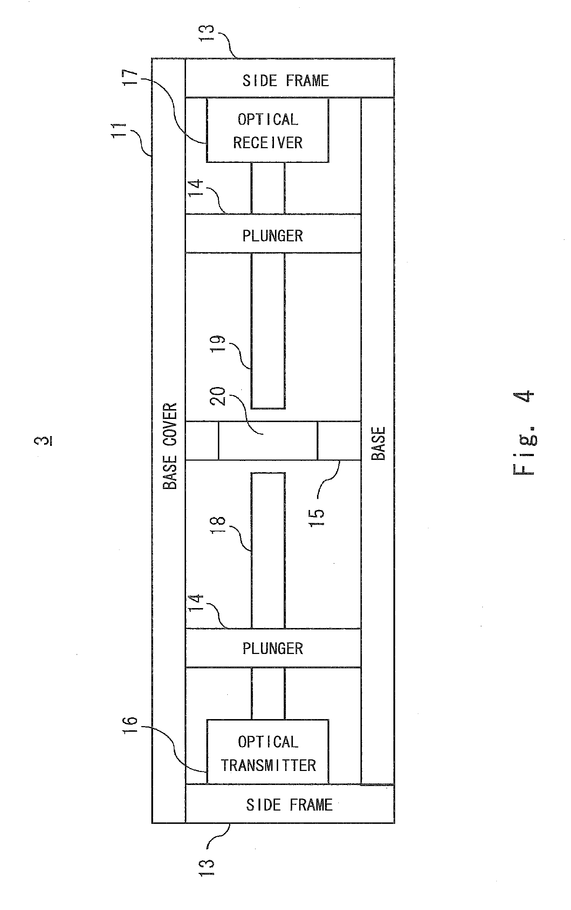

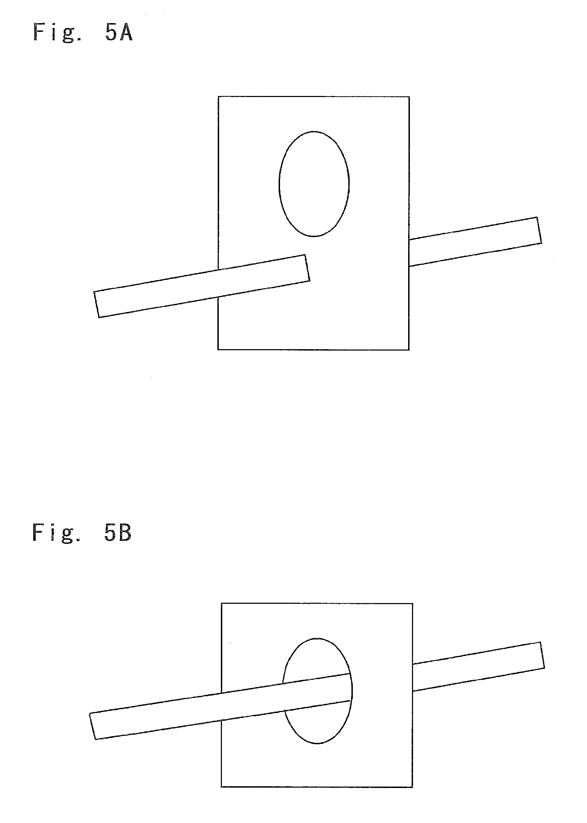

Referring next to Figs. 3, 4, 5A, and 5B, a control method based on the detection of riding of a rider on the inverted two-wheel vehicle 1 according to the first embodiment of the present invention will be described. Fig. 3 is a diagram showing the state of the step portion 3 when no rider is on the vehicle. Fig. 4 is a diagram showing the state of the step portion 3 when a rider is on the vehicle. Fig. 5A is a conceptual diagram showing the relationship between the laser beam and the slit plunger 15 when no rider is on the vehicle. Fig. 5B is a conceptual diagram showing the relationship between the laser beam and the slit plunger 15 when a rider is on the vehicle.

When no load is applied to the inverted two-wheel vehicle 1 as shown in Fig. 3 because no rider has stepped on the base cover 11, and when the laser beam output from the optical transmitter 16 is blocked and thus not received by the optical receiver 17 as shown in Fig. 5A, the inverted two-wheel vehicle 1 does not perform an inverted control. That is, the inverted two-wheel vehicle 1 remains stopped.

On the other hand, when a load is applied to the inverted two-wheel vehicle 1 as shown in Fig. 4 because the rider steps on the base cover 11, and when the laser beam output from the optical transmitter 16 is received by the optical receiver 17 as shown in Fig. 5B, the inverted two-wheel vehicle 1 performs an inverted control. That is, the inverted two-wheel vehicle 1 performs the control so as to travel in the inverted state.

As described above, when the laser beam does not pass through the path between the optical transmitter 16 and the optical receiver 17, the inverted control is not performed, while when the laser beam passes through the path between the optical transmitter 16 and the optical receiver 17, the inverted control is performed. Thus, the inverted two-wheel vehicle 1 is configured not to perform the inverted control when the laser beam does not pass through the path between the optical transmitter 16 and the optical receiver 17. This indicates that the inverted two-wheel vehicle 1 selects the control content that is considered safe, when a failure occurs in which the step portion 3 is not normally operated as a switch for detecting the riding state of the rider, thereby ensuring the safety of the rider. For example, the inverted control is constantly inhibited in the case where the riding state of the rider is not normally detected, for example, when the optical axis of the optical transmitter 16, the transmitting-side optical transmission path 18, the receiving-side optical transmission path 19, or the like deviates, or when the slit plunger 15 is not compressed and deformed as expected even if the rider is on the vehicle, so that the slit 20 is not located on the transmission path of the laser beam. Accordingly, the inverted two-wheel vehicle 1 remains stopped, and thus the safety of the person who is to ride on the inverted two-wheel vehicle 1 in the vicinity of the inverted two-wheel vehicle 1 is ensured.

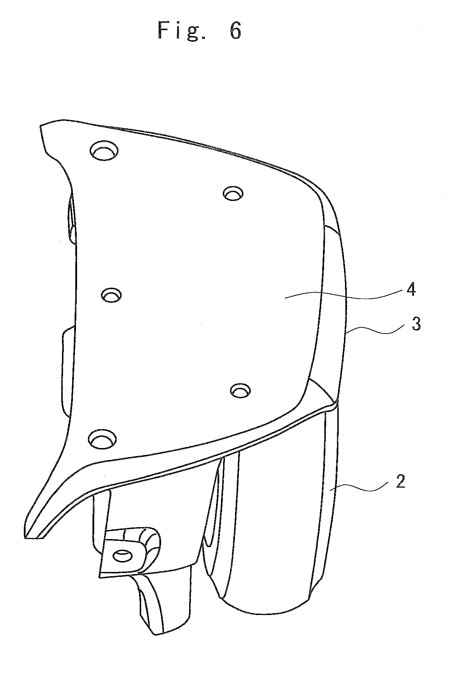

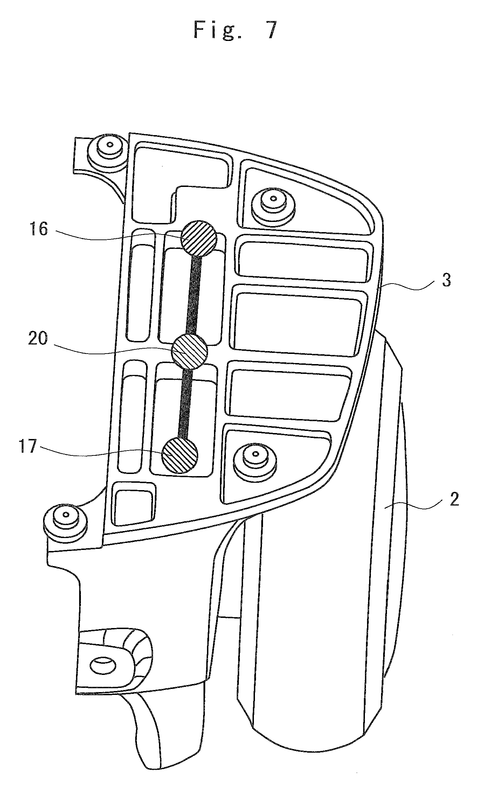

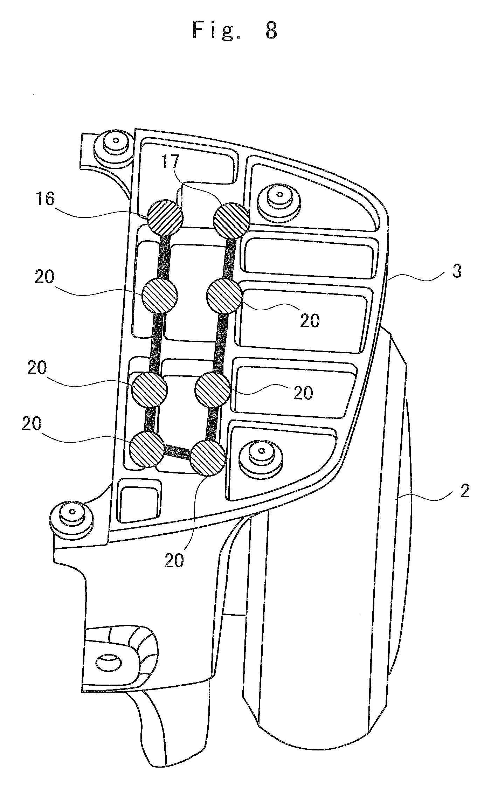

Referring next to Figs. 6 to 8, examples of the transmission path of the laser beam within the step portion 3 will be described. Fig. 6 is an appearance diagram of the set portion 3 according to the first embodiment of the present invention. Fig. 7 is a diagram showing a first example of the transmission path of the laser beam within the step portion 3. Fig. 8 is a diagram showing a second example of the transmission path of the laser beam within the step portion 3.

While Figs. 2 to 4 described above illustrate only one transmission path of the laser beam passing through the transmitting-side optical transmission path 18 and the receiving-side optical transmission path 19 between the optical transmitter 16 and the optical receiver 17, the number of transmission paths of the laser beam is not limited to one. A plurality of transmission paths may instead be provided. The shape of the transmission path of the laser beam is not limited to a linear shape. The transmission path of the laser beam may instead have any non-linear shape such as a shape having a linear portion and a bent portion, or a curved shape. Examples thereof will be described below.

Fig. 6 is an appearance diagram showing the right half of the step portion 3. In other words, Fig. 6 shows a portion of the step portion 3 on which the right foot of the rider is placed. Fig. 7 shows the inside of the step portion 3 (right half) shown in Fig. 6 when the base cover 11 is removed from the step portion 3. The shape of the transmission path of the laser beam may be a linear one so that the transmission path is disposed along the front-back direction of the inverted two-wheel vehicle 1, for example, as shown in Fig. 7. The transmission path of the laser beam in the left half of the step portion 3 is disposed similarly so as to be symmetrical to the transmission path in the right half thereof, and thus the description thereof is omitted.

Thus, in the case where the laser beam transmission paths are respectively disposed on the right foot side and the left foot side of the step portion 3, when it is detected that a laser beam passes through one of the right and left laser beam transmission paths, it can be determined that one foot is placed on the step portion 3, and when it is detected that the laser beam passes through both the right and left laser beam transmission paths, it can be determined that the rider is on the vehicle with both feet placed on the step portion 3. That is, in the case where a plurality of laser beam transmission paths are formed in the step portion 3, when it is detected that the laser beam passes through all the laser beam transmission paths, it is determined that the rider is on the vehicle, and the inverted control of the inverted two-wheel vehicle 1 is performed.

As described above, the laser beam transmission path may be formed so as to have a non-linear shape as shown in Fig. 8. In this case, when free space is used as the transmitting-side optical transmission path 18 and the receiving-side optical transmission path 19, a reflector may be provided at a portion where the laser beam transmission path is bent.

The detection of riding of a rider of the vehicle (detection of passage of a laser beam) and the inverted traveling control of the inverted two-wheel vehicle 1 based on the detection of riding of a rider on the vehicle as described above are performed by a control device 100 which is installed in the inverted two-wheel vehicle 1. The control device 100 will be described later. The control device 100 is installed in, for example, the base body 30 of the inverted two-wheel vehicle 1.

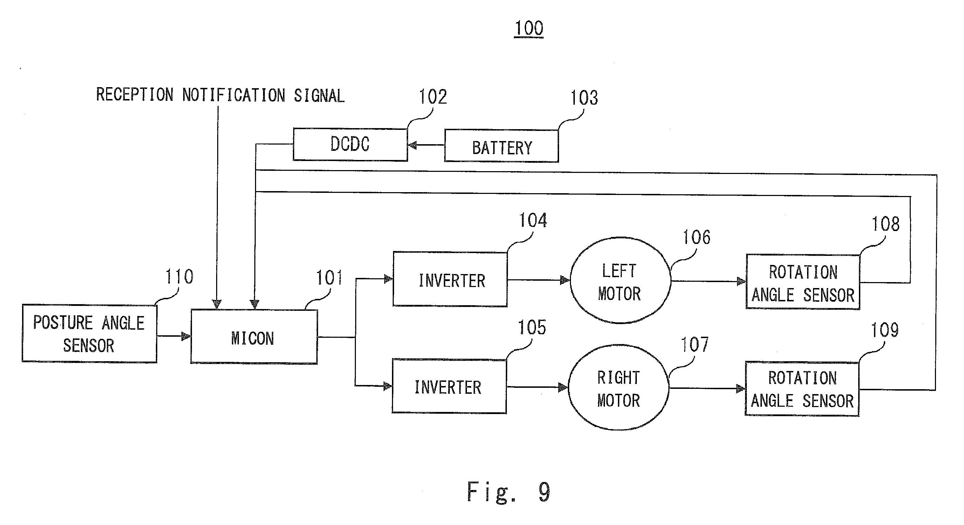

Referring next to Fig. 9, the structure of the control device 100 according to the first embodiment of the present invention will be described. Fig. 9 is a block diagram showing the structure of the control device 100 according to the first embodiment of the present invention.

The control device 100 includes a microcontroller 101 (hereinafter also referred to as "micon"), a DCDC converter (hereinafter also referred to as "DCDC") 102, a battery 103, inverters 104 and 105, motors 106 and 107, rotation angle sensors 108 and 109, and a posture angle sensor 110.

The micon 101 is an ECU (Engine Control Unit) which controls the motors 106 and 107 so as to maintain the inverted state as described above, based on a posture angle signal output from the posture angle sensor 110. The micon 101 includes a CPU (Central Processing Unit) and a storage unit, and executes a program stored in the storage unit, thereby executing processing as the micon 11 in this embodiment. Specifically, the program stored in the storage unit of the micon 101 includes a code that causes the CPU to execute processing in the micon 101 according to this embodiment. The storage unit includes any storage device capable of storing the program and various information pieces used for processing in the CPU. The storage device is, for example, a memory.

The micon 101 outputs a command value for controlling the motor 106 to the inverter 104. Further, the micon 101 outputs a command value for controlling the motor 107 to the inverter 105.

In this case, the micon 101 generates the command value to be output to the inverter 104 so as to perform a feedback control of the motor 106, based on a rotation angle signal which is output from the rotation angle sensor 108 and indicates a rotation angle of the motor 106. Further, the micon 101 generates the command value to be output to the inverter 105 so as to perform a feedback control of the motor 107, based on a rotation angle signal which is output from the rotation angle sensor 109 and indicates a rotation angle of the motor 107. The micon 101 operates based on electric power supplied from the DCDC 102.

In the first embodiment, as described above, the micon 101 detects that a rider is riding on the inverted two-wheel vehicle 1 and performs the inverted control of the vehicle (motors 106 and 107) according to the detection result. Specifically, when the optical receiver 17 is receiving the laser beam output from the optical transmitter 16, the optical receiver 17 continuously outputs, to the micon 101, a reception notification signal to notify that the laser beam is being received. When the micon 101 is receiving the reception notification signal output from the optical receive 17, the micon 101 determines that the rider is on the inverted two-wheel vehicle 1, and performs the inverted control of the vehicle. Further, when the micon 101 is not receiving the reception notification signal output from the optical receiver 17, the micon 101 determines that no rider is on the inverted two-wheel vehicle 1, and does not perform the inverted control of the vehicle.

The DCDC 102 transforms the voltage of the electric power supplied from the battery 103 into a suitable voltage to be supplied to the micon 101, and supplies the electric power to the micon 101.

The battery 103 supplies electric power necessary for the operation of the control device 100 to the control device 100. Specifically, the battery 103 supplies electric power necessary for the operation of the micon 101 to the DCDC 102.

The inverter 104 performs a PWM (Pulse Width Modulation) control based on the command value output from the micon 101, thereby generating a driving current to drive the motor 106, based on the electric power supplied from the battery 103, and supplying the driving current to the motor 106. The inverter 105 performs the PWM control based on the command value output from the micon 101, thereby generating a driving current to drive the motor 107, based on the electric power supplied from the battery 103, and supplying the driving current to the motor 107.

The motor 106 is driven based on the driving current supplied from the inverter 104. The motor 106 is driven to thereby rotate the left-side wheel 2 of the inverted two-wheel vehicle 1. The motor 107 is driven based on the driving current supplied from the inverter 105. The motor 107 is driven to thereby rotate the right-side wheel 2 of the inverted two-wheel vehicle 1.

The rotation angle sensor 108 detects a rotation angle of the motor 106, generates a rotation angle signal indicating the detected rotation angle, and outputs the rotation angle signal to the micon 101. The rotation angle sensor 109 detects a rotation angle of the motor 107, generates a rotation angle signal indicating the detected rotation angle, and outputs the rotation angle signal to the micon 101.

The posture angle sensor 110 detects a posture angle of the inverted two-wheel vehicle 1 in the front-back direction thereof when the rider applies a load to the step portion 3 in the front-back direction of the inverted two-wheel vehicle 1, and then outputs the posture angle signal, which indicates the detected posture angle, to the micon 101. The posture angle sensor 110 is composed of, for example, an acceleration sensor and a gyroscopic sensor so as to be able to detect the posture angle of the inverted vehicle 1.

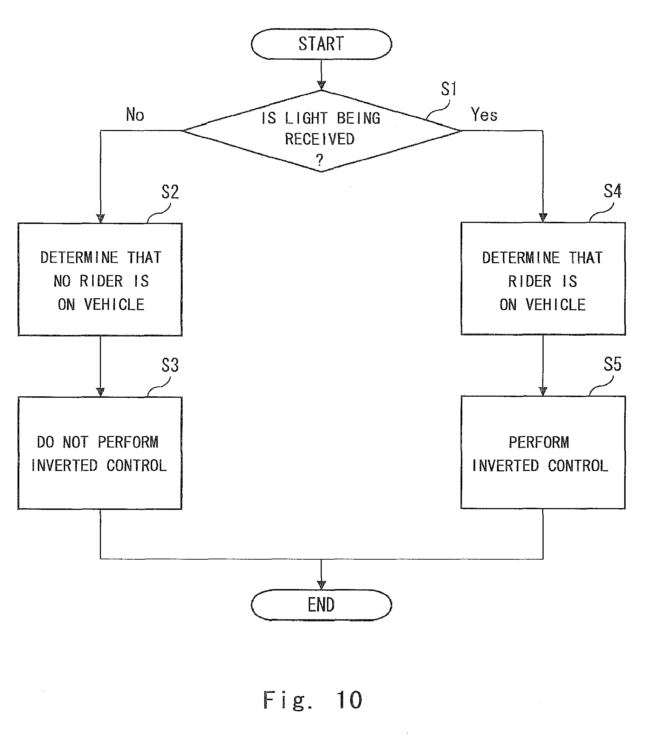

Referring next to Fig. 10, processing of the inverted two-wheel vehicle 1 according to the first embodiment of the present invention will be described. Fig. 10 is a flowchart showing processing of the inverted two-wheel vehicle 1 according to the first embodiment of the present invention.

The micon 101 determines if the optical receiver 17 is receiving the laser beam from the optical transmitter 16 (S1). Specifically, when the reception notification signal is output from the optical receiver 17, the micon 101 determines that the laser beam is being received (S1: No), and when the reception notification signal is not output from the optical receiver 17, the micon 101 determines that the laser beam is not being received (S1: Yes).

When it is determined that the laser beam is not being received by the optical receiver 17 (S1: No), the micon 101 determines that no rider is on the vehicle (S2). In this case, the micon 101 does not perform the inverted control of the inverted two-wheel vehicle 1 (S3). Specifically, the micon 101 does not drive the motors 106 and 107 and maintains the inverted two-wheel vehicle 1 in the stopped state.

On the other hand, when it is determined that the laser beam is being received by the optical receiver 17 (S1: Yes), the micon 101 determines that the rider is on the vehicle (S4). In this case, the micon 101 performs the inverted control of the inverted two-wheel vehicle 1 (S5). Specifically, the micon 101 drives the motors 106 and 107 based on the rotation angle signals output from the rotation angle sensors 108 and 109, and controls the inverted two-wheel vehicle 1 so that it travels in the inverted state.

As described above, in the first embodiment, when no load is applied to the base cover 11, the plungers 14 elastically support the base cover 11 so that the laser beam blocking portion of the split plunger 15 is located between the optical transmitter 16 and the optical receiver 17 to thereby block passage of the laser beam. Further, when a load is applied to the base cover 11, the plungers 14 are compressed and deformed so that the slit 20 of the split plunger 15 is located between the optical transmitter 16 and the optical receiver 17, to thereby allow passage of the laser beam.

This structure makes it possible to detect that a load is applied to the base cover 11, based on whether a laser beam passes through the path or not.

### <Second Embodiment of the Invention>

From the viewpoint of functional safety, an inverted two-wheel vehicle is required to have an additional function that detects the weight of a rider. In a service robot that is required to ensure dynamic stability as in the inverted two-wheel vehicle, there is a problem that it is difficult to ensure the safety when a user whose weight is more than the weight assumed at the design stage is on the vehicle. Accordingly, it is necessary to provide a mechanism that detects whether or not the weight of a rider is less than or equal to the weight assumed at the design stage.

In a second embodiment, the inverted two-wheel vehicle 1 that can also satisfy such a demand in the first embodiment will be described. The schematic structure of the inverted two-wheel vehicle 1 according to the second embodiment is similar to the schematic structure of the inverted two-wheel vehicle 1 according to the first embodiment described above with reference to Fig. 1, and thus the description thereof is omitted.

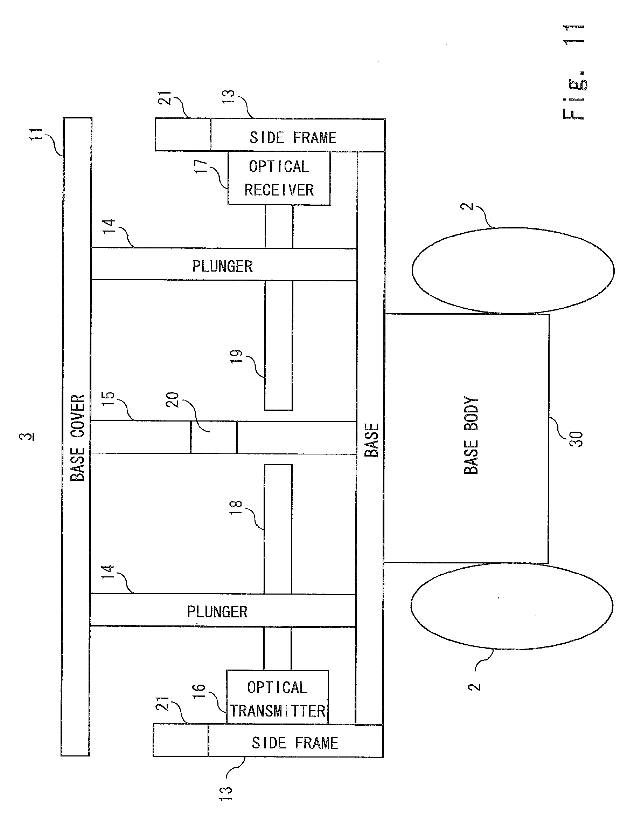

Referring next to Fig. 11, the internal structure of the step portion 3 according to the second embodiment of the present invention will be described. Fig. 11 is a diagram showing the internal structure of the step portion 3 according to the second embodiment of the present invention. The descriptions of components similar to those of the first embodiment are omitted.

Unlike the step portion 3 according to the first embodiment, the step portion 3 according to the second embodiment includes auxiliary plungers 21.

A lower portion of each auxiliary plunger 21 is connected in series with an upper portion of the corresponding side frame 13. Each auxiliary plunger 21 has a height that allows the base cover 11 to be elastically supported when the plungers 14 and the slit plunger 15 are compressed and deformed and the base cover 11 is displaced to a location where a laser beam passes through the slit 20. At least a part of each auxiliary plunger 21 includes an elastic body. The base cover 11 is elastically supported by the elastic force of the elastic body. In this case, the elastic body is, for example, rubber or a spring. The auxiliary plungers 21 each have a modulus of elasticity that allows the auxiliary plungers 21 to be compressed and deformed together with the plungers 14 and the slit plunger 15 by a load applied from the base cover 11 when a rider whose weight is more than an allowable weight steps on the base cover 11 and a load of a predetermined value or more is applied to the base cover 11. Any load that is assumed to be applied when the rider whose weight is more than the allowable weight is on the vehicle can be determined as the predetermined value. The predetermined value is a load greater than the load applied when the plungers 14 and the slit plunger 15 are compressed and deformed and the base cover 11 is elastically supported by the auxiliary plungers 21.

The step portion 3 may be provided with at least one auxiliary plunger 21, but it is preferable that the step portion 3 be provided with a plurality of auxiliary plungers 21 so as to stably support the base cover 11. In this case, the auxiliary plungers 21 may be arranged symmetrically about the center of gravity of the base cover 11, or about the central axis of the base cover 11 with respect to the front-back direction or the right-left direction, to thereby support the base cover 11 in a balanced manner.

Further, the location where the auxiliary plungers 21 are located is not limited to the above-mentioned location, as long as the auxiliary plungers 21 are provided so as to elastically support the base cover 11 when the plungers 14 and the slit plunger 15 are compressed and deformed and the base cover 11 is displaced to a location where a laser beam passes through the slit 20. For example, the auxiliary plungers 21 may be connected to an upper portion of the base 12.

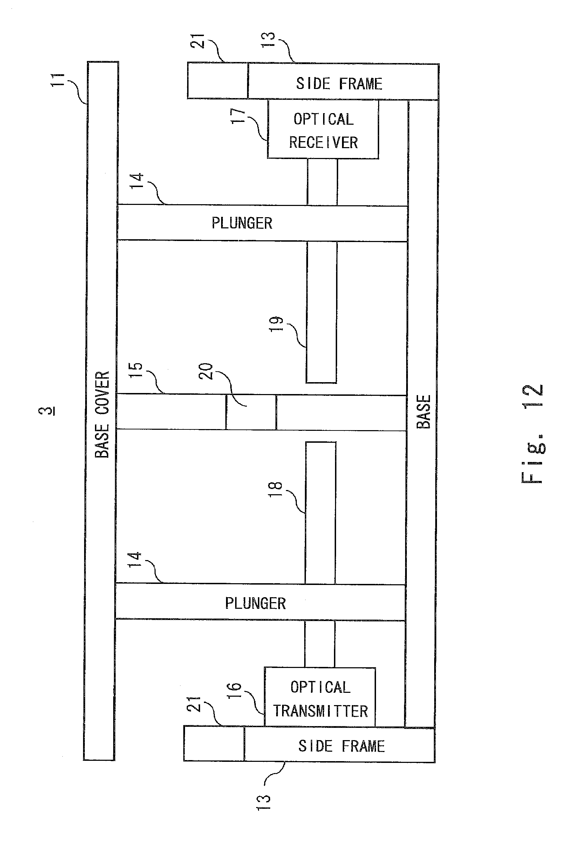

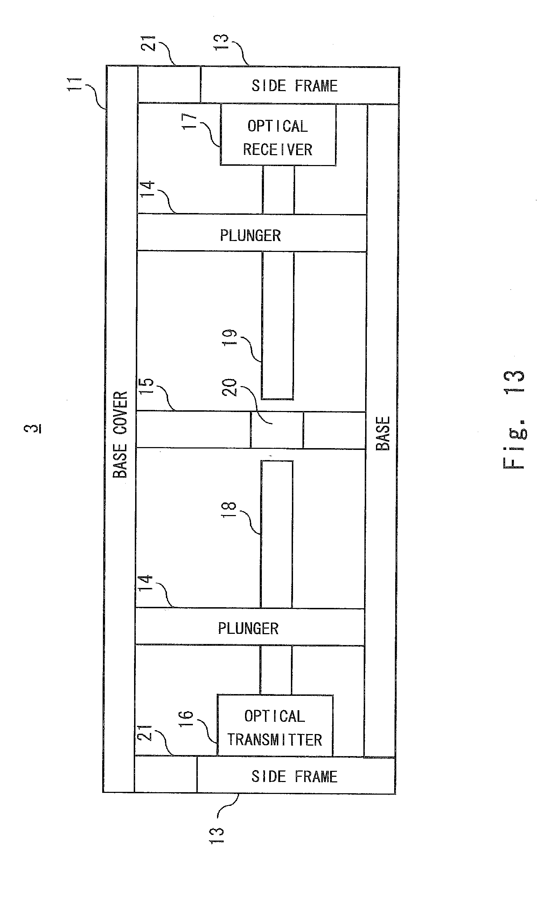

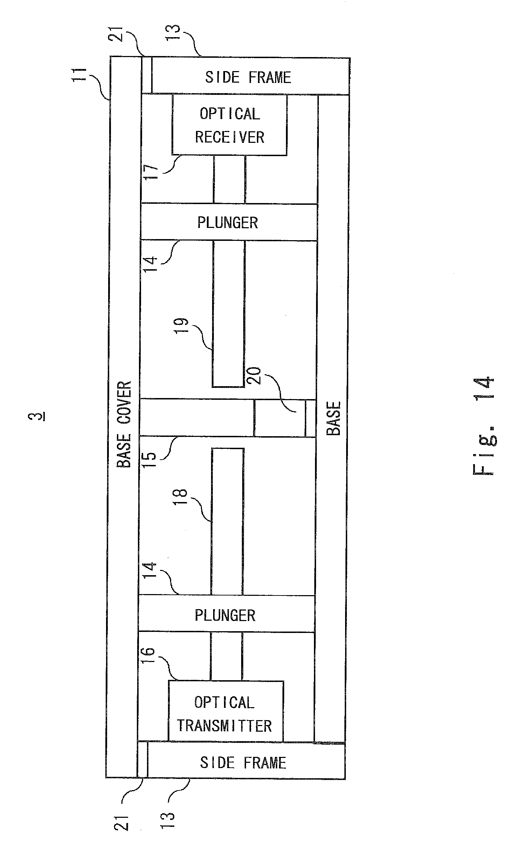

Referring next to Figs. 12 to 14, a method for detecting a rider on the inverted two-wheel vehicle 1 according to the second embodiment will be described. Fig. 12 is a diagram showing the state of the step portion 3 when no rider is on the vehicle. Fig. 13 is a diagram showing the state of the step portion 3 when the rider whose weight is less than or equal to the allowable weight is on the vehicle. Fig. 14 is a diagram showing the state of the step portion 3 when the rider whose weight is more than the allowable weight is on the vehicle.

The inverted two-wheel vehicle 1 does not perform the inverted control in the case where no load is applied to the base cover 11 when no rider is on the vehicle and the laser beam output from the optical transmitter 16 is not received by the optical receiver 17 as shown in Fig. 2. That is, the inverted two-wheel vehicle 1 remains stopped.

On the other hand, the inverted two-wheel vehicle 1 performs the inverted control in the case where a load is applied to the base cover 11 when the rider is on the vehicle and the laser beam output from the optical transmitter 16 is received by the optical receiver 17 as shown in Fig. 13. That is, the inverted two-wheel vehicle 1 performs the control so as to travel in the inverted state.

Meanwhile, the inverted two-wheel vehicle 1 does not perform the inverted control in the case where a load is applied to the base cover 11 when the rider is on the vehicle and the laser beam output from the optical transmitter 16 is not received by the optical receiver 17 as shown in Fig. 14. That is, the inverted two-wheel vehicle 1 remains stopped.

With these configurations, the inverted control in the situation where the weight of the rider is more than the allowable weight and thus the safety of the rider cannot be ensured can be inhibited even if the rider is on the vehicle. Therefore, the safety of the rider can be ensured.

The structure of the laser beam transmission path and the structure of the control device 100 are similar to those of the first embodiment, and thus the description thereof is omitted.

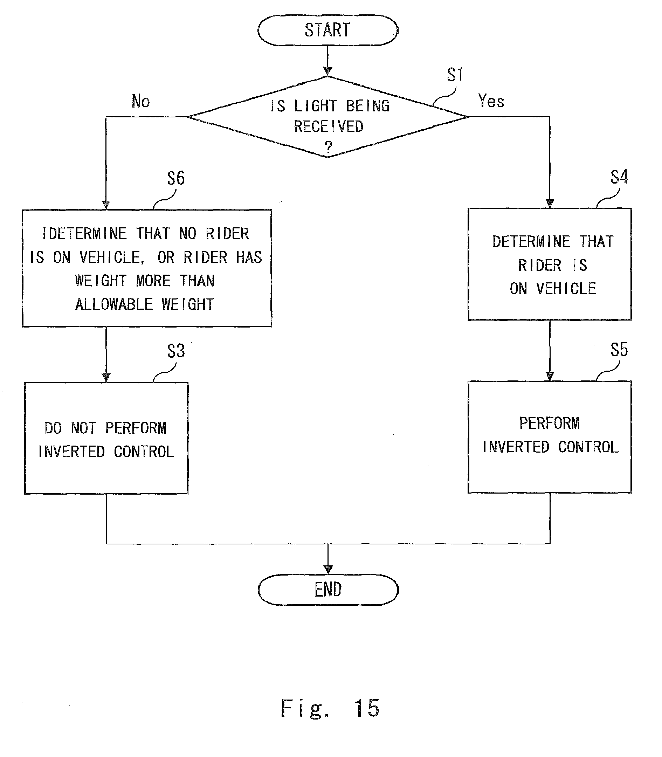

Referring next to Fig. 15, processing of the inverted two-wheel vehicle 1 according to the second embodiment of the present invention will be described. Fig. 15 is a flowchart showing processing of the inverted two-wheel vehicle 1 according to the second embodiment of the present invention.

When it is determined that the optical receiver 17 is not receiving the laser beam from the optical transmitter 16 (S1: No), the micon 101 determines that no rider is on the vehicle, or the weight of the rider is more than the allowable weight (S6). In this case, the micon 101 does not perform the inverted control of the inverted two-wheel vehicle 1 (S3). Note that when it is determined that the laser beam is being received (S1: Yes), a process similar to that in the first embodiment is carried out, and thus the description thereof is omitted.

As described above, in the second embodiment, the auxiliary plungers 21 elastically support the base cover 11 at a location where the base cover 11 is displaced when a load is applied to the base cover 11 and the plungers 14 are compressed and deformed. Further, the auxiliary plungers 21 are compressed and deformed together with the plungers 14 so that the laser beam blocking portion of the split plunger 15 is located between the optical transmitter 16 and the optical receiver 17 to thereby block passage of the laser beam, when a load of a predetermined allowable load value or more is applied to the base cover 11.

This structure makes it possible to detect that a load greater than an assumed load is applied to the base cover 11, based on whether or not the laser beam is allowed to pass.

### <Other Embodiments of the Invention>

In the first and second embodiments described above, it is detected that a rider is on the vehicle and that a rider whose weight is equal to or more than an assumed weight is on the vehicle, based on whether or not the laser beam is allowed to pass. Alternatively, signals other than an optical signal, such as a laser beam, may also be used. For example, a determination may be made based on whether or not an electrical signal, such as electricity (current), is allowed to pass.

In this case, the portion corresponding to the split 20 in the slit plunger 15 may be formed of a conductive material which conducts electricity, and the portions other than the portion may be formed of an insulating material which does not conduct electricity and provides insulation. The transmitting-side optical transmission path 18 and the receiving-side optical transmission path 19 may be electrical transmission paths through which electricity flows. The electrical transmission paths are, for example, conductors through which electricity flows. A power transmission portion that outputs electricity may be provided in place of the optical transmitter 16, and a power reception portion that receives the electricity output from the power transmission portion may be provided in place of the optical receiver 17. When the power reception portion is receiving the electricity output from the power transmission portion, the power reception portion continuously outputs the reception notification signal to the micon 101.

In this case, when the conductive material, which is provided in place of the slit 20, is located on the laser beam transmission path between the power transmission portion and the power reception portion (between the electrical transmission path provided in place of the transmitting-side optical transmission path 18 and the electrical transmission path provided in place of the receiving-side optical transmission path 19), each electrical transmission path is formed to contact the conductive material and to allow electricity to pass through the path between the power transmission portion and the power reception portion.

In this structure, the micon 101 determines, in step S1, whether the power reception portion is receiving the electricity from the power transmission portion. When it is determined that the electricity is not being received (S1: No), the micon 101 can determine that no rider is on the vehicle, or the weight of the rider is more than the allowable weight (S6). Further, when it is determined that the electricity is being received (S1: Yes), the micon 101 determines that the rider (whose weight is less than or equal to the allowable weight) is on the vehicle (S4).

The return modulus of the elastic body of each of the various plungers 14, 15, and 21 described above may be determined such that the plungers 14, 15, and 21 are slowly returned when the rider steps off of the base cover 11. For example, any return modulus may be determined such that it takes a predetermined time, such as a few tenths of a second, until the slit 20 deviates from the position on the laser beam transmission path. This makes it possible to prevent the slit 20 from deviating from the position on the laser beam transmission path even in the situation where the road surface on which the inverted two-wheel vehicle 1 travels has irregularities and the feet of the rider come off the base cover 11 for a moment. Accordingly, it is possible to prevent the inverted control from being suspended after erroneously determining that the rider has gotten off the vehicle although the rider has not gotten off the vehicle yet. Moreover, the program of the micon 101, or the electronic components and the like of the control device 100, eliminates the need for providing an algorithm, a mechanism, or the like to detect the situation in which the feet of the rider come off the base cover 11 for a moment and determine that the rider has not gotten off the vehicle yet. This leads to a reduction in cost.

Note that the present invention is not limited to the embodiments described above, and can be modified as appropriate without departing from the scope of the invention.

The embodiments described above illustrate the case in which the control system has a single structure, but the control system may have a multiplexed structure to improve the safety of control. For example, when the control system is configured to have a duplex structure, another set of the components 101 to 105 and 108 to 110, which drive the inverted two-wheel vehicle 1 (motors 106 and 107) described above, may be provided. If a failure is detected in the control system corresponding to one of the sets, the control system in which the failure is detected may be caused to retract and the inverted two-wheel vehicle 1 (motors 106 and 107) may be driven only by the remaining control system.

### Reference Signs List

- 1: INVERTED TWO-WHEEL VEHICLE
- 2: WHEEL
- 3: STEP PORTION
- 4: COVER
- 11: BASE COVER
- 12: BASE
- 13: SIDE FRAME
- 14: PLUNGER
- 15: SLIT PLUNGER
- 16: OPTICAL TRANSMITTER
- 17: OPTICAL RECEIVER
- 18: TRANSMITTING-SIDE OPTICAL TRANSMISSION PATH
- 19: RECEIVING-SIDE OPTICAL TRANSMISSION PATH
- 20: SLIT
- 21: AUXILIARY PLUNGER
- 30: BASE BODY
- 100: CONTROL DEVICE
- 101: MICON
- 102: DCDC
- 103: BATTERY
- 104, 105: INVERTER
- 106, 107: MOTOR
- 108, 109: ROTATION ANGLE SENSOR
- 110: POSTURE ANGLE SENSOR

## Claims

1. An inverted vehicle that travels with a rider riding thereon, the inverted vehicle comprising:
a riding portion on which the rider rides;
an output portion that outputs a signal in a lower portion of the riding portion;
an input portion that receives, in the lower portion of the riding portion, an input of the signal output from the output portion;
a passing/blocking portion connected so as to be located between the output portion and the input portion in the lower portion of the riding portion, the passing/blocking portion including: a passing portion that allows the signal to pass therethrough; and a blocking portion that blocks passage of the signal;
a main support portion that elastically supports the riding portion so that the blocking portion is located between the output portion and the input portion to block passage of the signal when no load is applied to the riding portion, and is compressed and deformed so that the passing portion is located between the output portion and the input portion to allow passage of the signal when a load is applied to the riding portion; and
a control portion that performs an inverted traveling control of the inverted vehicle when the signal is passing through a path between the output portion and the input portion.

2. The inverted vehicle according to Claim 1, further comprising an auxiliary support portion that elastically supports the riding portion at a location where the riding portion is deformed when a load is applied to the riding portion and the main support portion is compressed and deformed,
wherein the auxiliary support portion is compressed and deformed together with the main support portion so that the blocking portion is located between the output portion and the input portion to block passage of the signal when a load equal to or more than a predetermined allowable load is applied to the riding portion.

3. The inverted vehicle according to Claim 1 or 2, wherein
the signal is an optical signal,
the passing portion is a light-passing hole through which the optical signal passes, or a light transmitting portion formed of a material that allows the optical signal to be transmitted therethrough, and
the blocking portion is a light blocking portion formed of material that blocks transmission of the optical signal.

4. The inverted vehicle according to Claim 1 or 2, wherein
the signal is an electrical signal,
the passing portion is a conducting portion formed of a material that conducts the electrical signal, and
the blocking portion is an insulating portion formed of a material that blocks the electrical signal.

5. The inverted vehicle according to any one of Claims 1 to 4, wherein the control portion inhibits the inverted traveling control of the inverted vehicle when the passage of the signal between the output portion and the input portion is blocked.

6. A load detection device comprising:
a load receiving portion that receives an externally-applied load;
an output portion that outputs a signal in a lower portion of the load receiving portion;
an input portion that receives, in the lower portion of the load receiving portion, an input of the signal output from the output portion;
a passing/blocking portion connected so as to be located between the output portion and the input portion in the lower portion of the load receiving portion, the passing/blocking portion including: a passing portion that allows the signal to pass therethrough; and a blocking portion that blocks passage of the signal; and
a main support portion that elastically supports the load receiving portion so that the blocking portion is located between the output portion and the input portion to block passage of the signal when no load is applied to the load receiving portion, and is compressed and deformed so that the passing portion is located between the output portion and the input portion to allow passage of the signal when a load is applied to the load receiving portion,
wherein upon receiving an input of the signal, the input portion outputs a notification signal to notify that the signal is passing through a path between the output portion and the input portion.
